# EUROPEAN PATENT APPLICATION

(11) **EP 2 487 929 A2**
(43) Date of publication of application: **15.08.2012**
(21) Application number: 12151020.0
(22) Date of filing: 13.01.2012
(51) Int. Cl.: H04R 3/00

(54) **Sound signal output apparatus, speaker apparatus, and sound signal output method**

(30) Priority: 14.02.2011 JP 2011028625
(71) Applicant: Sony Corporation, Tokyo 108-0075 (JP)
(72) Inventor: Tsuchiya, Shinpei, Minato-ku, Tokyo 108-0075 (JP); Asada, Kohei, Minato-ku, Tokyo 108-0075 (JP); Tsukamoto, Tetsurou, Minato-ku, Tokyo 108-0075 (JP)
(74) Representative: Robinson, Nigel Alexander Julian

(57) **Abstract**

A sound signal output apparatus includes: a wearing state determination unit which determines whether or not a connected speaker apparatus is fitted to an ear of a user; a volume adjustment unit which adjusts volume of a sound signal to be supplied to the speaker apparatus; and an accumulative computation unit which computes an accumulative value of output volume in accordance with a volume level and sound output time of the sound signal, causes the volume adjustment unit to execute volume regulation when the accumulative value reaches a regulatory value, and does not compute the accumulative value during a period in which the wearing state determination unit determines that the speaker apparatus is not fitted to the ear.

## Description

The present disclosure relates to a sound signal output apparatus, a speaker apparatus, and a sound signal output method, and particularly to a technique according to which a sound signal to be output to a speaker apparatus is accumulated as an output volume.

The disclosures described in Japanese Unexamined Patent Application Publication Nos. 3-123199, 64-1400, and 2009-159441 relate to a technique which is not for regulating reproduction sound pressure but for detecting wearing/non-wearing state of headphones in ears.

For example, music and the like have generally been enjoyed with a mobile reproduction apparatus called an audio player, a media player, or the like.

Recently, there has been a trend to regulate supply of a loud reproduction signal from a reproduction apparatus main body to headphones for a long time mainly in Europe in relation to sound reproduction performed with such a reproduction apparatus to which headphones or earphones are connected, in order to prevent hearing loss.

In order to prevent loud sound from being listened to for a long time, a countermeasure can be considered in which an output voltage of a reproduction apparatus main body which is currently reproducing music is cumulatively counted and a maximum value of the output voltage is forcibly decreased when the cumulative value reaches a reference value at which there is a concern that auditory perception may adversely be affected.

However, the counter measure may have a possibility of a disadvantageous operation so as to give unnecessary restriction of the volume if a user's actual listening state is not considered. For example, if the user is not wearing headphones or the like to listen, the output voltage during the period is accumulated, and the output volume is shifted to a low level at a certain timing.

It is desirable to appropriately perform volume control as volume regulation while performing the volume regulation in order to prevent hearing loss.

According to an embodiment of the present disclosure, there is provided a sound signal output apparatus including: a wearing state determination unit which determines whether or not a connected speaker apparatus is fitted to an ear of a user; a volume adjustment unit which adjusts volume of a sound signal to be supplied to the speaker apparatus; and an accumulative computation unit which computes an accumulative value of output volume in accordance with a volume level and sound output time of the sound signal, causes the volume adjustment unit to execute volume regulation when the accumulative value reaches a regulatory value, and does not compute the accumulative value during a period in which the wearing state determination unit determines that the speaker apparatus is not fitted to an ear.

In addition, the sound signal output apparatus according to the embodiment may further include: a signal outside audible band generating unit which generates a signal outside an audible band; and a signal superimposing unit which superimposes the signal outside the audible band generated by the signal outside audible band generating unit on a sound signal to be supplied to the speaker apparatus. Moreover, the wearing state determination unit may determine whether or not the speaker apparatus is fitted to the ear based on detection of the signal outside the audible band in a received sound signal supplied from the speaker apparatus.

According to another embodiment of the present disclosure, there is provided a speaker apparatus including: a speaker which outputs sound by an output sound signal supplied from a connected sound signal output apparatus; a sound receiving element for reflected sound in the ear, which is arranged so as to receive reflected sound in the ear of a user in a state in which the speaker apparatus is fitted to the ear of the user; and an output terminal which supplies a received sound signal obtained by the sound receiving element to the connected sound signal output apparatus.

According to still another embodiment of the present disclosure, there is provided a sound signal output method including: determining whether or not a connected speaker apparatus is fitted to an ear of a user; computing an accumulative value of output volume in accordance with a volume level and sound output time of a sound signal to be supplied to the speaker apparatus only during a period in which it is determined by the wearing state determination unit that the speaker apparatus is fitted to the ear; and executing volume regulation on the sound signal to be supplied to the speaker apparatus when the accumulative value reaches a regulatory value.

According to the present disclosure, it is detected whether or not a speaker apparatus connected to a sound signal output apparatus is fitted to an ear of a user, and output volume is accumulated. That is, an accumulative value of the output volume is not computed during a period in which the speaker apparatus is not fitted to the ear, namely a period in which there is no burden exerted on auditory perception of the user. In so doing, the accumulative value here corresponds to an accumulative value only during the period in which the speaker apparatus is fitted to the ear of the user, which is an appropriate value as an accumulative value for a countermeasure against hearing loss.

According to the present disclosure, it is possible to detect whether or not the speaker apparatus (headphones or earphones) is fitted to ear regardless of how the user of the sound signal output apparatus uses the apparatus and to update the accumulative value of the output volume only when the speaker apparatus is fitted to the ear. Thus, it is possible to appropriately control volume based on the accumulative value.

Further particular and preferred aspects of the present invention are set out in the accompanying independent and dependent claims. Features of the dependent claims may be combined with features of the independent claims as appropriate, and in combinations other than those explicitly set out in the claims.

Embodiments of the invention will now be described, by way of example only, with reference to the accompanying drawings in which:
Figs. 1A to 1E are explanatory diagrams of cumulative value computation according to an example embodiment of the present disclosure;
Fig. 2 is a block diagram according to a first example embodiment of the present disclosure;
Figs. 3A to 3C are block diagrams showing details of a headphone wearing state determination unit according to an example embodiment;
Fig. 4 is an explanatory diagram showing configurations of a plug formed on the side of a headphone apparatus according to an example embodiment and of a jack formed on the side of a reproduction apparatus main body;
Figs. 5A and 5B are explanatory diagrams of an internal configuration and operations of a headphone apparatus according to an example embodiment;
Fig. 6 is a flowchart of reproduction volume accumulative computation and gain regulation processing according to an example embodiment;
Figs. 7A and 7B are flowcharts of accumulative computation control processing according to an example embodiment.
Fig. 8 is a block diagram according to a second example embodiment;
Fig. 9 is a block diagram according to a third example embodiment;
Fig. 10 is a block diagram according to a fourth example embodiment; and
Figs. 11A and 11B are diagrams showing equivalent circuits when ferrite beads are used.

Hereinafter, description will be given of example embodiments of the present disclosure in the following order. In the embodiments, a reproduction apparatus called an audio player or a media player is exemplified as an example of the sound signal output apparatus of the present disclosure, and a headphone apparatus connected to the reproduction apparatus is exemplified as an example of the speaker apparatus of the present disclosure.
<1. Outline of accumulative computation operation according to example embodiments>
<2. First example embodiment>
<3. Second example embodiment>
<4. Third example embodiment>
<5. Fourth example embodiment>

### <1. Outline of accumulative computation operation according to example embodiments>

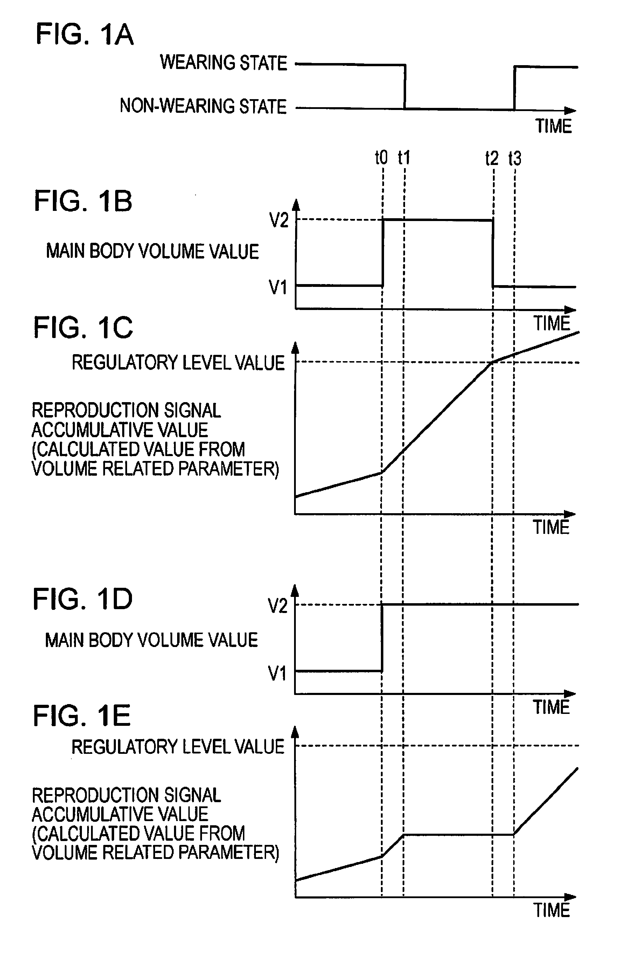

First, description will be given of output volume accumulative computation as countermeasure against hearing loss according to embodiments with reference to Figs. 1A to 1E.

For example, in consideration of a concern that listening to loud sound for a long time causes hearing loss, the reproduction apparatus continuously and accumulatively add output volume output to the headphones during the reproduction. Then, when the accumulative value reaches a predetermined regulatory value set in advance, the volume is forcibly turned down. For example, a gain to be given to a sound signal output to the headphones is restricted. This is an appropriate countermeasure against hearing loss.

However, there is also a case in which appropriate gain restriction is not performed in practice by simply accumulating the output volume.

For example, when the headphone apparatus is removed from the ear, time accumulative counting of the output voltage of the reproduction apparatus main body is continued if music is being reproduced. In addition, even when not the headphone apparatus but an external speaker with an amplifier or the like reproduces the music, the time accumulative counting of the output volume of the reproduction apparatus main body is continued in the same manner.

Moreover, there is also a case in which a user is not wearing the headphones and is not listening to the music even if the music is being reproduced.

Then, even the time and the volume during the period when no burden is exerted on the user's auditory perception are added to the accumulative value, and the gain is unnecessarily controlled in some cases.

A specific example will be described with reference to Figs. 1A to 1C.

Fig. 1A shows a wearing state of a headphone apparatus in an ear of a user of the reproduction apparatus. That is, the drawing shows a state in which the user removes the headphone apparatus, which was fitted to the ear at timing t1, and wears the headphone apparatus again at timing t3.

Figs. 1B and 1C shows a temporal change in the volume of the reproduction apparatus main body and a change in the accumulative value of a reproduction signal (reproduction volume) of the reproduction apparatus when the processing of detecting the wearing state of the headphone apparatus into the ears is not performed.

Since the time recording of the output voltage is performed based on the volume setting state of the reproduction apparatus main body as shown in the drawings, the accumulation of the time recording is gradual in the state in which the volume corresponds to v1.

Since the volume is turned up from v1 to v2 at timing t0, the time recording accumulation state is changed and becomes steep.

Since the volume is turned down from v2 to v1 at timing t2, the time recording accumulation state is changed, and the accumulation is continued at the same inclination as that in the accumulation until the timing t0. From the drawings, it is possible to understand the use state of the reproduction apparatus by the user to some extent.

In this case, however, the time recording accumulation is continued regardless of the fact that the headphone apparatus is not fitted to the ear in practice during the time from the timing t1 to the timing t3.

Since the accumulative value of the sound pressure exceeds a regulatory level at the timing t2, the upper limitation of the volume level thereafter is forcibly changed to the volume v1 by a sound pressure regulation function as shown in Fig. 1B regardless of the wearing state of the headphones.

On the other hand, Figs. 1D and 1E shows a temporal change in the volume of the reproduction apparatus main body and a change in the reproduction volume accumulative value according to the embodiments.

The time recording accumulation is also performed at the inclination corresponding to v1 when the volume is v1 in this case as well.

Since the volume is turned up from v1 to v2 at the timing t0, the time recording accumulation state is changed and becomes steep.

The accumulation is continued at the steep inclination from the timing t0 to the timing t1.

Since the headphone apparatus is removed from the ear during the period from the timing t1 to the timing t3, the accumulation is not continued, and the accumulative value becomes a constant value.

When the headphone apparatus is fitted again at the timing t3, the accumulation is restarted at the timing. Since the volume is v2 at this time, the accumulation is continued at the same inclination as that in the accumulation from the timing t0 to the timing t1.

That is, the user can listen to the music with a desired volume even after the timing t3 in this case.

As described above, the target of the computation of the output volume accumulative value as a reference of the sound pressure regulation control is limited to the headphones wearing period in order to perform the sound pressure regulation control and take countermeasures against hearing loss, according to the embodiments. In so doing, it is possible to regulate the sound pressure in order to protect auditory perception while adapting to the use state of the reproduction apparatus such as a media player or the like by the user without excessively regulating the sound pressure.

For this reason, a wearing state determination unit which determines whether the connected headphone apparatus is in a wearing state or in a non-wearing state in the user's ear, a volume adjustment unit which adjusts volume of a sound signal to be supplied to the headphone apparatus, and an accumulative computation unit which computes output volume accumulative value in accordance with a volume level of the sound signal and the sound output time, according to the embodiments. The accumulative computation unit causes the volume adjustment unit to execute volume regulation when the accumulative value reaches a regulatory value. In addition, the accumulative computation unit does not execute the computation of the accumulative value during the period which is determined to be a non-wearing state by the wearing state determination unit.

### <2. First example embodiment>

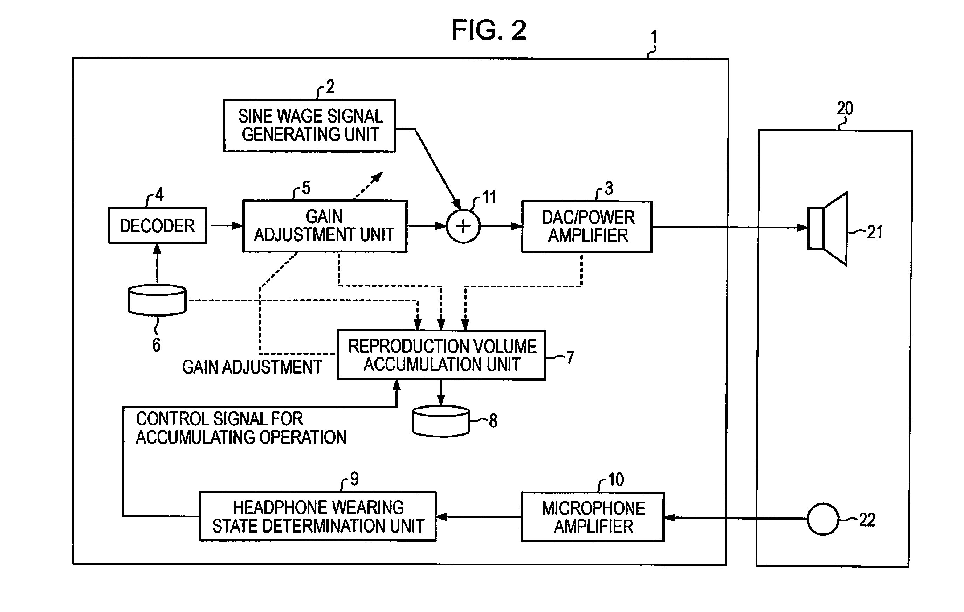

Fig. 2 is a diagram illustrating a first embodiment in which a reproduction apparatus main body 1 and a headphone 20 according to an embodiment are provided. This block diagram shows internal configurations of the reproduction apparatus main body 1 and the headphone apparatus 20.

First, the internal configuration of the headphone apparatus 20 will be described with reference to Fig. 2.

The headphone apparatus 20 is provided with a speaker 21 and a sound receiving element 22.

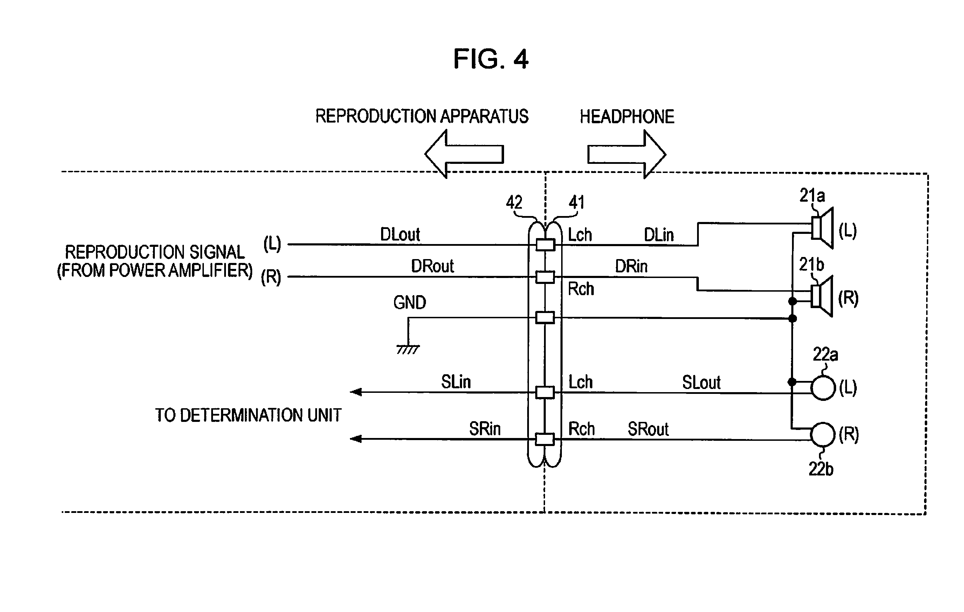

The speaker 21 reproduces a sound signal supplied from the reproduction apparatus main body 1. The sound signal is supplied from the reproduction apparatus main body 1 via an L/R channel path (refer to Fig. 4) which will be described later.

The sound receiving element 22 receives a signal outside the audible band, which will be described later, superimposed on the sound signal supplied from the reproduction apparatus main body 1 to the speaker 21. The received signal is used for detecting whether or not the headphone apparatus 20 is fitted to the ear. The sound receiving element 22 may be an ordinary microphone which can be arranged in the headphone 20.

The sound receiving element 22 is a sound receiving element for reflected sound in the ear, which is arranged to receive the reflected sound in the ear of the user in a state in which the headphone apparatus 20 is fitted to the user's ear.

The headphone apparatus 20 is provided with an output terminal which supplies a received sound signal obtained by the sound receiving element 22 to the connected reproduction apparatus main body 1, as will be described later with reference to Fig. 4.

Next, description will be given of the internal configuration of the reproduction apparatus main body 1. As shown in Fig. 2, the reproduction apparatus main body 1 is provided with a sound source 6, a decoder 4, a gain adjustment unit 5, a signal superimposer 11, a DAC/power amplifier 3, a reproduction volume accumulation unit 7, a storage unit 8, a microphone amplifier 10, and a headphone wearing state determination unit 9.

The sound source 6 stores sound signal data. As a specific configuration, the sound source 6 may be configured by a solid-state memory such as a flash memory, or an HDD (Hard Disk Dive), for example.

Alternatively, the sound source 6 may be configured not by a built-in recording medium but by a drive apparatus corresponding to a mobile recording medium such as a memory card with a built-in solid-state memory, an optical disc such as a CD (Compact Disc), a DVD (Digital Versatile Disc), or the like, a magneto-optical disc, a holographic memory, or the like.

It is matter of course that both of the built-in type memory such as a solid-state memory, an HDD, or the like and the drive apparatus for the mobile recording medium may be mounted.

The sound signal data is written in or read from the sound source 6 based on the control by a control unit which is not shown in the drawings.

In addition, the sound source 6 stores sound signal data, for example, in a compressed and coded state based on a predetermined sound compression coding method.

The decoder 4 performs expanding processing on the compressed audio data read from the sound source 6.

The gain adjustment unit 5 adjusts a gain in order to adjust the sound signal expanded by the decoder 4 to have an appropriate output level.

The sine wave signal generating unit 2 outputs a sine wave signal outside the audible band. The frequency of the sine wave signal outside the audible band may be set to about 40 kHz, for example. Then, the signal outside the audible band is superimposed on the sound signal, which has been output from the gain adjustment unit 5, by the signal superimposer 11.

The DAC/power amplifier 3 performs D/A conversion processing on the sound signal with a signal outside the audible band superimposed thereon, converts the sound signal into an analog signal, and further amplifies the analog signal to have a predetermined level in order to drive the speaker 21.

Then, the analogue signal is supplied to the speaker 21 of the headphone apparatus 20, and the speaker 21 is driven by the signal.

In addition, the DAC/power amplifier 3 may be replaced with a digital power amplifier.

The microphone amplifier 10 amplifies the received sound signal received by the sound receiving element 22 on the side of the headphone apparatus 20 to have a predetermined level.

The headphone wearing state determination unit 9 receives the received sound signal form the microphone amplifier 10, extracts the signal outside the audible band from the received sound signal, and determines whether or not the headphone apparatus 20 is fitted to the ear by analyzing the size of the signal outside the audible band.

Then, the headphone wearing state determination unit 9 transmits the determination result as a control signal to the reproduction volume accumulation unit 7.

The reproduction volume accumulation unit 7 accumulates the reproduction volume of the speaker 21 in the storage unit 8 based on whether or not the headphone apparatus 20 is fitted to the ear. The control signal output from the headphone wearing state determination unit 9 represents whether or not the headphone apparatus 20 is fitted to the ear. Accordingly, it is possible to control the start and the stop of the accumulation of the reproduction volume with the control signal.

In addition, the reproduction volume can be obtained from an output level from the sound source 6, the temporal change in the gain value of the gain adjustment unit 5, and the temporal change in the gain value of the DAC/power amplifier 3, for example.

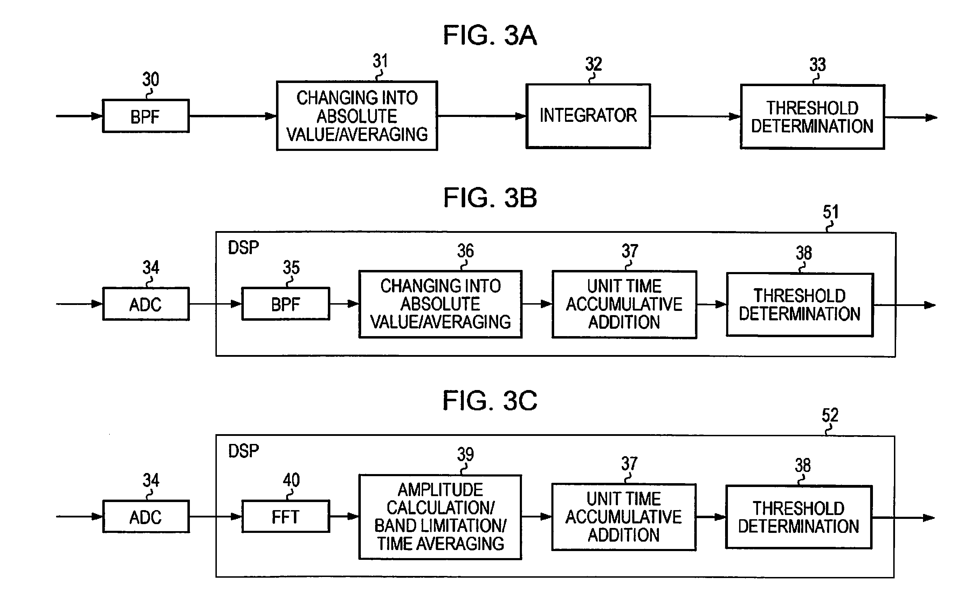

Next, description will be given of various configuration examples of the headphone wearing state determination unit 9 with reference to Figs. 3A to 3C.

Fig. 3A shows a configuration when analog processing is performed on the input received sound signal. Figs. 3B and 3C show cases in which digital processing is performed on the input received sound signal.

In Fig. 3A, the received sound signal collected by the sound receiving element 22 is input to a band pass filter (BPF) 30 via the microphone amplifier 10. Since the BPF 30 allows only a signal at a frequency in a necessary range to pass and does not allow (attenuates) signals at other frequencies to pass, the BPF 30 can allow only the signal outside the audible band to pass in this case. That is, the BPF 30 extracts only the signal outside the audible band.

The extracted signal outside the audible band is subjected to time averaging by a processing unit 31. In this case, negative values may be inverted and averages as positive values, or only positive values may be extracted and averaged. With such a processing unit 31, it is possible to obtain more stable output.

The output is input to an integrator 32, and accumulative addition is performed in terms of unit time to obtain an added value. A threshold determination unit 33 performs determination on the value. That is, the threshold determination unit 33 determines whether or not the headphone apparatus is fitted to the ear depending on whether or not the value is greater than a threshold value (a constant value).

It is also possible to perform the determination processing of the headphone wearing state determination unit 9 through digital computation by DSP (Digital Signal Processors) 51 and 52. Figs. 3B and 3C show specific examples.

In Fig. 3B, the received sound signal collected by the sound receiving element 22 is input to an A/D converter 34. The A/D converter 34 converts the analog signal into a digital signal.

The digital signal is input to the DSP 51 which determines whether or not the headphone apparatus 20 is fitted to the ear. In the DSP 51, substantially the same processing as the analog processing is performed. That is, BPF 35 extracts the signal outside the audible band, the processing unit 36 averages the extracted signal, and the accumulative addition unit 37 accumulatively adds the unit time of the averaged value. Then, the threshold determination unit 38 performs determination based on the accumulatively added value. That is, it is determined whether or not the headphone apparatus is fitted to the ear based on whether or not the accumulatively added value is greater than a threshold value (a constant value).

Fig. 3C shows an example in which a DSP 52 is used and the signal outside the audible band is extracted by FFT (Fast Fourier Transformation) 40.

In such a case, the FFT 40 performs frequency conversion on the signal outside the audible band, the processing unit 39 extracts the amplitude of the signal outside the audible band and performs band limitation processing, time averaging, and accumulative addition of the unit time of the value averaged by the accumulative addition unit 37, and the threshold determination unit 38 performs determination thereby to determine whether or not the headphone apparatus is fitted to the ear.

It is possible to extract the signal outside the audible band more precisely than the BPF 35 by extracting the signal outside the audible band by the FFT 40.

Next, Fig. 4 is a diagram showing a detail of the connection between the reproduction apparatus main body 1 and the headphone apparatus 20 according to the first embodiment.

The reproduction apparatus main body 1 and the head phone apparatus 20 are connected to each other by inserting a connection plug 41 of the headphone apparatus 20 into a connection jack 42 of the reproduction apparatus main body 1.

As paths which supply sound signals from the reproduction apparatus main body 1 to the headphone apparatus 20, a path for an L channel Lch (for the left ear) and a path for an R channel Rch (for the right ear) are formed. Although the sound signal output from the DAC/power amplifier 3 is supplied to the speaker 21 through a single line in the aforementioned Fig. 2, this drawing is depicted like this for simplification. The detailed connection is as shown in Fig. 4.

As shown in the drawing, a sound signal for the L channel Lch is supplied to an output terminal DLout, and a sound signal for the R channel Rch is supplied to an output terminal DRout.

On the side of the headphone apparatus 20, terminals DLin and DRin are provided as terminals corresponding to DLout and DRout, and the sound signals for the L channel Lch and the R channel Rch are supplied to the speakers 21a and 21b by connecting the connection jack 42 and the connection plug 41.

As paths which receive sound signals collected from the sound receiving elements 22a and 22b, a path for the L channel Lch (for the left ear) and a path for the R channel Rch (for the right ear) are formed. Although signals collected by the sound receiving element 22 are supplied to the microphone amplifier through a single line in the aforementioned Fig. 2, this drawing is depicted like this for simplification. The detailed connection is as shown in Fig. 4.

The sound may be collected with the use of any one of the L channel Lch and the R channel Rch.

As shown in the drawings, the received sound signal collected by the sound receiving element 22a is supplied to an output terminal SLout, and the received sound signal collected by the sound receiving element 22b is supplied to an output terminal SRout. On the side of the reproduction apparatus main body 1, SLin and SRin are provided as terminals corresponding to SLout and SRout, and the received sound signals of the L channel Lch and the R channel Rch are supplied to the microphone amplifier by connecting the connection jack 42 and the connection plug 41.

Although only one set of the microphone amplifier 20 and the headphone wearing state determination unit 9 is shown in Fig. 2, two sets may be provided corresponding to the sound receiving element 22a and 22b.

In such a case, there is also a case in which it is determined that only one of the headphone wearing state determination unit 9 of one channel and the headphone wearing state determination unit 9 of the other channel is in the wearing state. This corresponds to a case in which the user wears the headphone apparatus only in one ear. In such a case, the state is regarded as a wearing state in relation to the accumulation operation which will be described later.

However, a configuration is also applicable in which it is determined that the headphone apparatus is in the wearing state based on an AND condition of the two headphone wearing state determination units 9.

In addition, another configuration example can also be considered in which two sets, each of which includes only the microphone amplifier 20, are provided, and a synthesized signal of the two microphone amplifiers 20 is supplied to one headphone wearing state determination unit 9.

In Fig. 4, one terminal of the speaker 21a, one terminal of the speaker 21b, one terminal of the sound receiving element 22a, and one terminal of the sound receiving element 22b are further connected to a GND on the side of the reproduction apparatus main body 1 with the use of one terminal of the connection jack 42 and the connection plug 41.

With such a configuration, it is possible to exchange the sound signal and the received sound signal on the basis of the GND of the reproduction apparatus main body 1.

According to the embodiment, the received sound signals by the sound receiving elements 22a and 22b are supplied to the reproduction apparatus main body 1, and it is possible to use only five terminals of the connection jack 42 and the connection plug 41 for necessary connection with the connection terminal configuration shown in Fig. 4. In so doing, it is possible to maintain compatibility with an existing headphone apparatus (a headphone apparatus with a five-pole plug which has a so-called noise cancelling function).

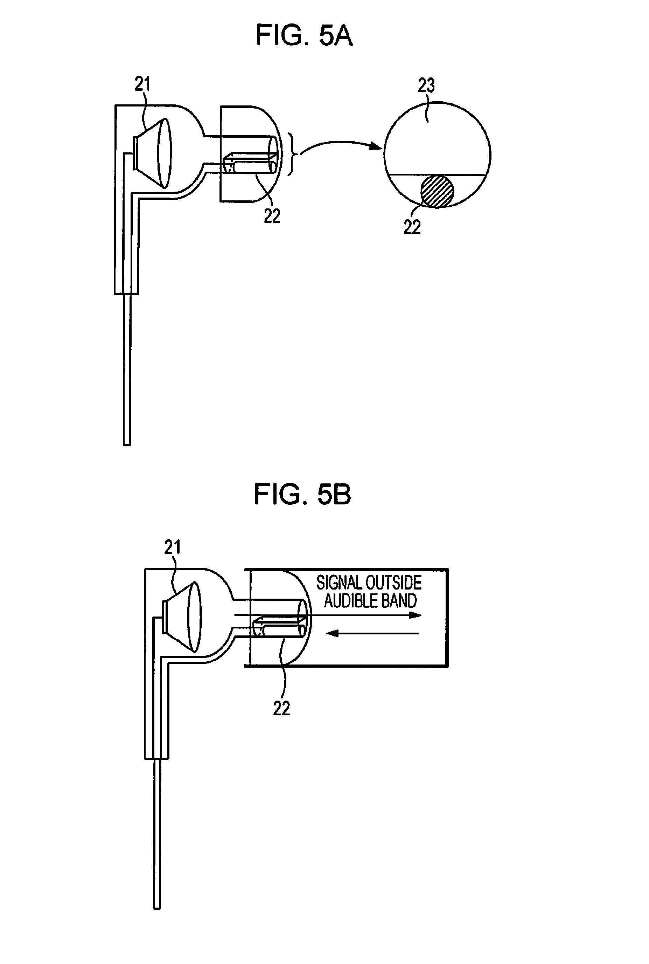

Figs. 5A and 5B are explanatory diagrams of an internal configuration and operations of the headphone apparatus 20 according to the embodiment.

The left diagram in Fig. 5A is a perspective view from a direction of a side surface of the headphone apparatus 20. The right diagram is a cross-sectional view thereof.

As shown in the drawings, the inside of the case body of the headphone apparatus 20 is partitioned by a dedicated space 23 such that the sound receiving element 22 does not directly collect the sound emitted from the speaker 21. The sound receiving element 22 is positioned on the lower side of the dedicated space 23. In this state, the sound receiving element 22 does not directly collect the emitted sound signal even if the sound signal with a signal outside the audible band superimposed thereon is output from the speaker 21.

Fig. 5B is a diagram simulating a state in which the headphone apparatus 20 is fitted to the ear. In such a case the sound signal with the signal outside the audible band superimposed thereon, which has been output from the speaker 21, is propagated within the space of the dedicated space 23, the sound signal is reflected in the ear, and the sound receiving element 22 can collect the reflected signal, in the state in which the headphone apparatus 20 is fitted to the ear.

That is, the sound receiving element 22 receives the sound signal and the signal outside the audible band as reflected sound in the ear.

Such a received signal is supplied to the reproduction apparatus main body 1. The reproduction apparatus main body 1 extracts the signal outside the audible band from the received signal and determines whether or not the headphone apparatus 20 is fitted to the ear. The operation is as described above with reference to Figs. 3A to 3C.

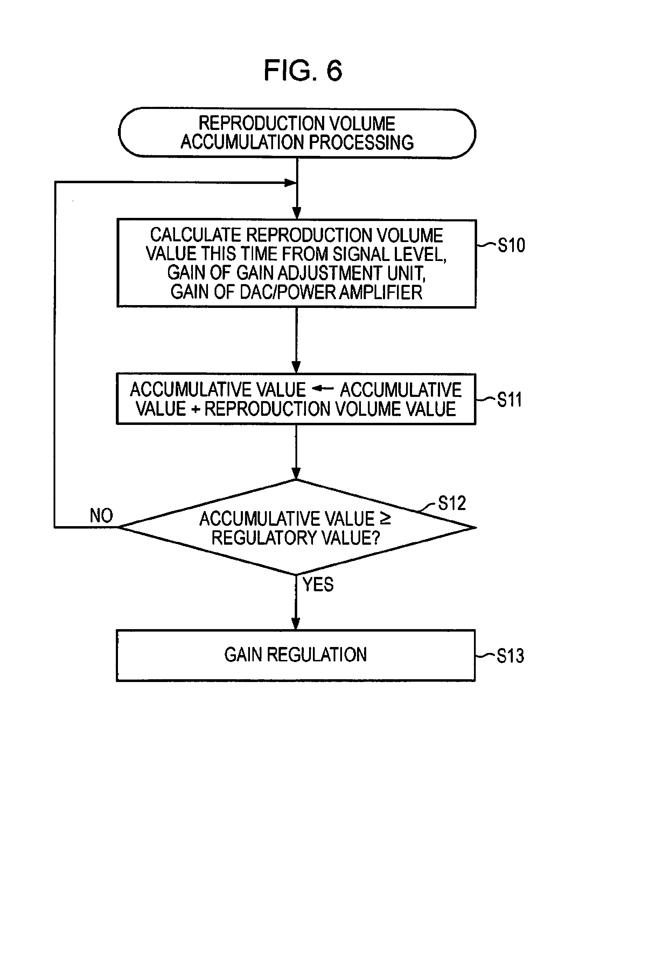

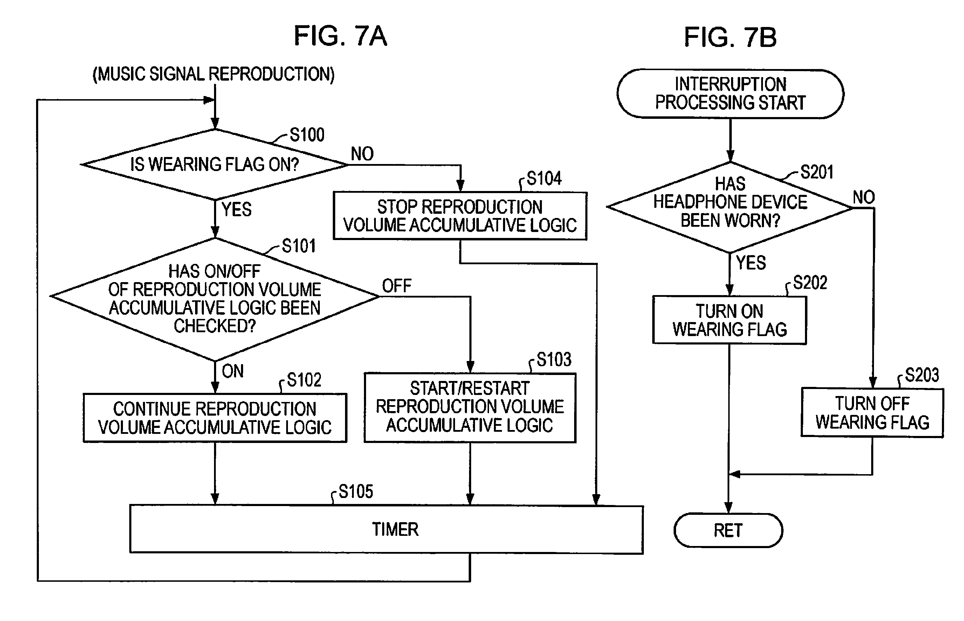

Figs. 6 to 7B are flowcharts showing processing operations to be executed in the first embodiment described above. Fig. 6 shows accumulation processing and gain control processing. Fig. 7A is a flowchart showing main operations. Fig. 7B is a flowchart showing interruption processing which is started when the headphone apparatus 20 is fitted to the ear or removed from the ear.

The processing of the reproduction volume accumulation unit 7 will be described with reference to Figs. 6 to 7B.

First, Fig. 6 shows accumulation processing and gain control processing in the reproduction volume accumulation unit 7.

During the reproduction, the reproduction volume accumulation unit 7 continuously executes the processing in Fig. 6.

First, in Step S10, the reproduction volume accumulation unit 7 inputs a signal level of the reproduced audio data, a gain of the gain adjustment unit 5, a gain of the DAC/power amplifier 3, and the like to obtain a reproduction volume value this time. For example, average values of a level of output audio data from the sound source 6, a gain value of the gain adjustment unit 5, and a gain value of the DAC/power amplifier 3 are respectively obtained as a certain unit period, and a coefficient value as current volume is set based on the average values.

That is, a coefficient corresponding to the inclination of the accumulative value shown in Fig. 1E is set. A value obtained by multiplying the coefficient by a target unit time value is regarded as a reproduction volume value this time. This can be understood as a value of the current speaker output volume.

In Step S11, the reproduction volume accumulation unit 7 adds the reproduction volume value this time to the current accumulative value to obtain a new accumulative value. Then, the reproduction volume accumulation unit 7 causes the storage unit 8 to store the new accumulative value.

Until the accumulative value reaches a predetermined regulatory value in Step S12, Steps S10 and S11 are repeatedly executed for each unit time. Accordingly, the accumulative value is increased with the inclination according to the volume of the moment as shown in Fig. 1E.

If the accumulative value reaches the regulatory value at a certain moment, the reproduction volume accumulation unit 7 moves on to Step S13 to perform gain regulation by the gain adjustment unit 5.

For example, a maximum gain is regulated to a gain corresponding to the volume V1 shown in Fig. 1B. In so doing, the output volume regulation as a countermeasure against hearing loss is executed.

Although the state after performing the gain regulation is not shown in Fig. 6, a configuration can be considered in which the gain regulation is released after elapse of a predetermined period.

In addition, it can be considered that the accumulative value itself is also reset after elapse of a predetermined period.

Although the reproduction volume accumulation unit 7 constantly performs the accumulative value computation in the above Fig. 6 during the reproduction, the accumulative value computation processing in Steps S10 and S11 itself is stopped in some cases according to the embodiment.

This will be described with reference to Figs. 7A and 7B.

Fig. 7B shows the interruption processing executed at each predetermined moment by the reproduction volume accumulation unit 7. This interruption may be physical interruption.

In Step S201, the reproduction volume accumulation unit 7 checks a control signal of the headphone wearing state determination unit 9, namely a determination signal for determining whether or not the headphone apparatus is fitted.

Then, the determination result represents that the headphone apparatus is being fitted, the reproduction volume accumulation unit 7 turns on a wearing flag in Step S202.

On the other hand, the determination result represents that the headphone apparatus is not fitted, the reproduction volume accumulation unit 7 turns off the wearing flag in Step S203.

Fig. 7A shows overall operations including the processing in Fig. 6 executed by the reproduction volume accumulation unit 7. In this drawing, the processing in Steps S10 and S11 in Fig. 6 corresponds to a reproduction volume accumulative logic.

In Step S100, the reproduction volume accumulation unit 7 determines whether or not the headphone apparatus 20 is fitted to the ear depending on the state of the wearing flag set in the aforementioned interruption processing. If the wearing flag is turned on, it is determined that the headphone apparatus 20 is currently fitted to the ear, and the processing proceeds to Step S101.

In Step S101, the reproduction volume accumulation unit 7 checks whether or not the accumulating operation of the reproduction volume, namely the processing in Steps S10 and S11 in Fig. 6 is currently being executed.

If it is determined that the accumulating operation of the reproduction volume is being executed, the reproduction volume accumulation unit 7 moves on to Step S102 and continues the accumulation processing of the reproduction volume.

If it is determined that the accumulation operation of the reproduction volume is stopped, the reproduction volume accumulation unit 7 moves on to Step S103 and starts or restarts the accumulation processing of the reproduction volume.

When it is confirmed that the wearing flag is turned off in Step S100, the reproduction volume accumulation unit 7 determines that the headphone apparatus 20 is not fitted to the ear and moves on to Step S104. Then, the reproduction volume accumulation unit 7 stops the reproduction accumulating operation.

After the completion of the processing in Steps S102, S103, and S104, the processing operation proceeds to Step S105. In Step S105, constant standby time is set, and the above operations are repeated after the standby time. The standby time may be set to zero.

By performing the processing in Figs. 6 to 7B, the reproduction volume accumulation unit 7 performs the accumulative value computation as described above with reference to Fig. 1E.

That is, the reproduction volume accumulation unit 7 detects whether or not the headphone apparatus 20 is fitted to the ear regardless of how the user of the reproduction apparatus main body 1 uses the headphone apparatus 20 and accumulates the reproduction signal from the reproduction apparatus main body 1 only when the headphone apparatus 20 is fitted to the ear. Therefore, the gain regulation based on such an accumulative value becomes appropriate sound pressure regulation processing.

Since the reproduction apparatus main body 1 and the headphone apparatus 20 can be connected to each other with a five-pole connector, it is possible to apply the present disclosure while maintaining the compatibility with the apparatus in the related art.

### <3. Second example embodiment>

Next, description will be given of a second embodiment.

This embodiment is an application example in which the reproduction apparatus main body and the headphone apparatus have noise cancelling functions.

There are two kinds of noise cancelling methods including a feedback method (hereinafter, referred to as an FB method) and a feedforward method (hereinafter, referred to as an FF method). As the second embodiment, description will be given of the FF method. Then, description will be given of the FB method as a third embodiment.

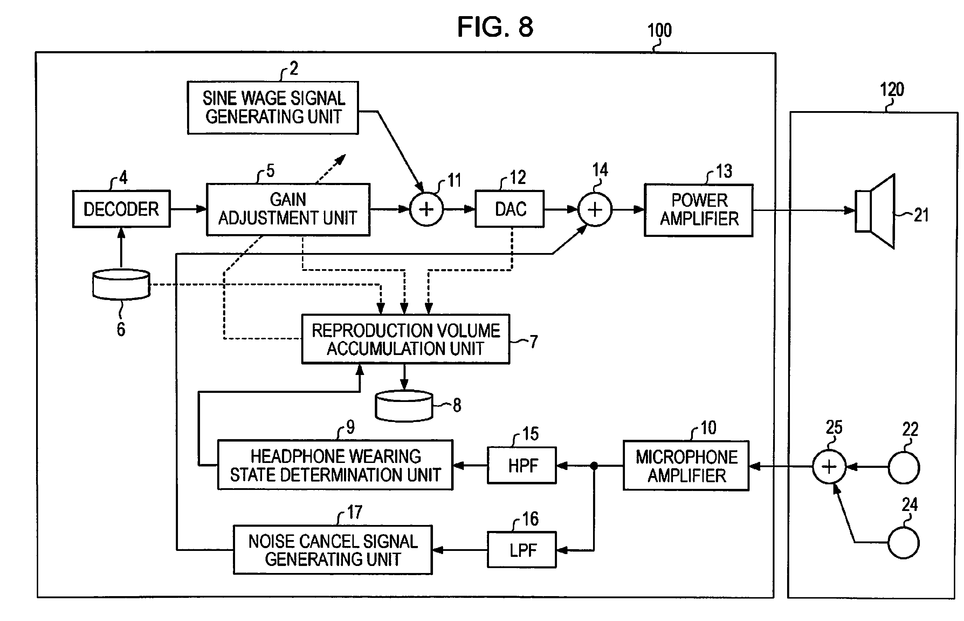

Fig. 8 is a block diagram according to a second embodiment. In the following description, the same reference numerals will be given to the same components as those in the above description, and the description thereof will be omitted.

The headphone apparatus 120 has a configuration in which a noise cancelling microphone 24 and an adder 25 are additionally provided as well as the speaker 21 and the sound receiving element 22.

In the case of the FF method, the noise cancelling microphone 24 is arranged outside the case body of the headphone apparatus 120 and configured so as to be able to collect extraneous noise.

The adder 25 superimposes a signal received by the noise cancelling microphone 24 on a signal collected by the sound receiving element 22.

The reproduction apparatus main body 100 has a configuration in which an LPF 16 (Low-Pass Filter), a noise cancelling signal generating unit, and an adder 14 are additionally provided.

The adder 14 is added between the DAC 12 (D/A conversion) and a power amplifier 13. In addition, the adder 14 may be added after the power amplifier 13.

In the case of digital processing, addition is performed before the DAC 12.

The received sound signal delivered from the headphone apparatus 120 is input to an HPF 15 (High-Pass Filter) and the LPF 16 (Low-Pass Filter) via the microphone amplifier 10. In so doing, the headphone apparatus 120 can separate the signal added by the adder 25 into a signal outside the audible band and a noise component.

This separation processing can also be realized by digital processing after subjecting the output from the microphone amplifier 10 to A/D conversion (DC).

The signal outside the audible band extracted by the HPF 15 is input to the headphone wearing state determination unit 9, and it is determined based on the signal whether or not the headphone apparatus 20 is fitted to ear. The detail thereof is the same as that in the first embodiment.

The noise component extracted by the LPF 16 is input to the noise canceling signal generating unit 17, and a noise cancelling signal based on the noise component is output from the noise cancelling signal generating unit 17. For example, the noise cancelling signal generating unit 17 generates a noise cancelling signal with a reversed-phase waveform of the noise component.

The noise cancelling signal is superimposed on the sound signal by the adder 14. If the sound signal is reproduced by the speaker 21 within the ear, the noise in the ear is cancelled.

As described above, it is possible to realize appropriate accumulation of reproduction volume in accordance with whether or not the headphone apparatus 120 is fitted to ear even by the reproduction apparatus main body 100 and the headphone apparatus 120 with noise cancelling functions.

According to the present disclosure, it is possible to precisely detect whether or not the headphone apparatus 120 is fitted to the ear and accumulate a reproduction signal from the reproduction apparatus main body 100 only when the headphone apparatus 120 is fitted to the ear regardless of how the user of the reproduction apparatus uses the apparatus. Therefore, it is possible to appropriately control sound pressure based on the accumulative value.

### <4. Third example embodiment>

Next, description will be given of the third embodiment. This embodiment is a case in which the noise cancelling method is the FB method.

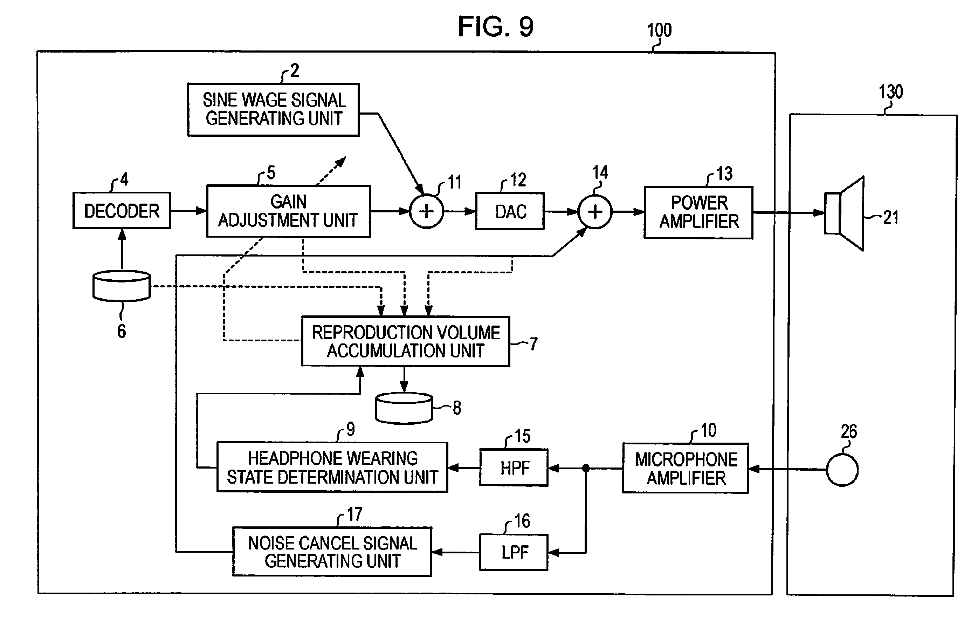

Fig. 9 shows the reproduction apparatus main body 100 and a headphone apparatus 130 according to the third embodiment. In the following description, the same reference numerals will be given to the same components as those in the above description, and the description thereof will be omitted.

Since this embodiment is based on the FB method, a noise cancelling microphone 26 is arranged within the case body of the headphone apparatus 130 to collect a sound signal including noise within the ear.

Here, the microphone 26 also functions as a sound receiving element which receives the reflected sound of the signal outside the audible band to be used for determining whether or not the headphone apparatus 130 is being fitted.

That is, this embodiment is configured by providing a sound receiving element for reflected sound and a sound receiving element which also functions as a noise collecting sound receiving element based on the FB method.

The configuration of the reproduction apparatus main body 100 is substantially the same as that in the above second embodiment. However, the configuration of the reproduction apparatus main body 100 is different from that in the second embodiment in that the noise cancelling signal generating unit 17 generates a noise cancelling signal by filtering based on the FB method.

The signal outside the audible band extracted by the HPF 15 is input to the headphone wearing state determination unit 9, and it is determined based on the signal whether or not the headphone apparatus 130 is fitted to the ear. The detail is the same as that in the first embodiment.

The sound signal and the noise component extracted by the LPF 16 are input to the noise cancelling signal generating unit 17. The noise cancelling signal generating unit 17 generates a noise cancelling signal with a reversed-phase waveform of the noise component from the input signal.

The noise cancelling signal is superimposed on the sound signal by the adder 14. By reproducing the sound signal within the ear by the speaker 21, the user can listen to the reproduced sound in which the noise has been cancelled.

As described above, it is possible to realize appropriate accumulation of reproduced volume in accordance with whether or not the headphone apparatus 130 is fitted to ear even in the reproduction apparatus main body 100 and the headphone apparatus 130 with noise cancelling functions.

In such a case, a microphone can function both as a microphone for noise cancelling and as a microphone for determining whether or not the headphone apparatus 130 is fitted, and therefore, it is possible to simplify the configuration on the side of the headphone apparatus 130.

### <5. Fourth example embodiment>

Next, description will be given of a fourth embodiment. According to this embodiment, it is detected whether or not a headphone apparatus 140 is fitted to the ear, with the use of a frequency-dependent resistance unit. In the frequency-dependent resistance unit, a resistance value is changed by a low-frequency signal and a high-frequency signal (the signal outside the audible band in this case). As an example of the frequency-dependent resistance unit, description will be given of an example in which it is detected by a ferrite bead B1 whether or not the headphone apparatus 140 is fitted to the ear.

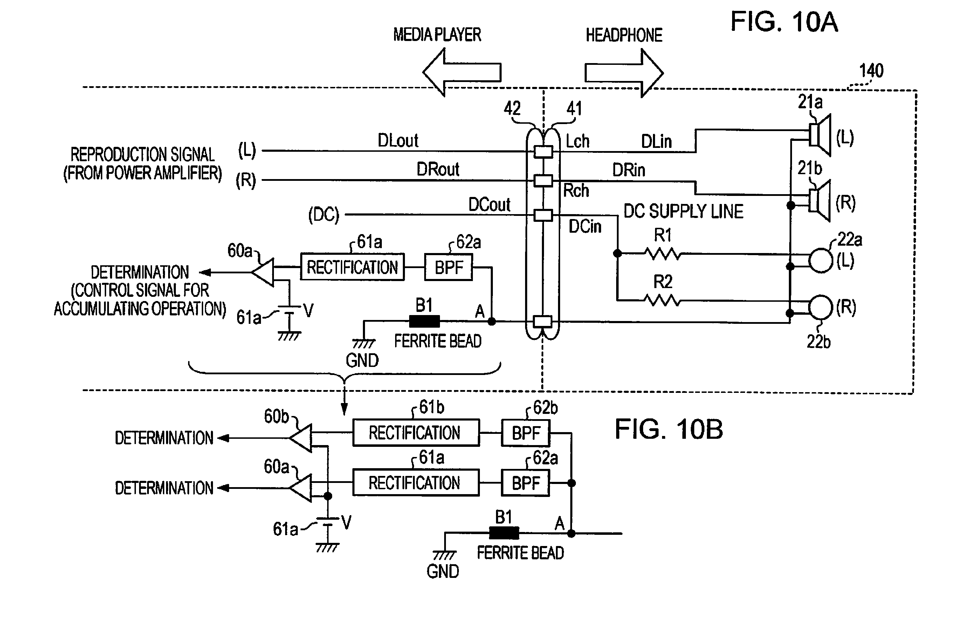

Fig. 10A is a block diagram according to the fourth embodiment. The same reference numerals will be given to the same components as those in the above description, and the description thereof will be omitted.

In the headphone apparatus 140, direct voltage DC is supplied to an output terminal DCout on the side of a reproduction apparatus main body 200. Since DCin is provided on the side of the headphone apparatus as an input terminal corresponding to the output terminal DCout, the direct voltage DC is supplied to the sound receiving elements 22a and 22b via resistances R1 and R2 by connecting the connection jack 42 and the connection plug 41.

The resistances R1 and R2 are resistances for adjusting current.

A terminal which is different from a terminal to which the direct voltage DC from the sound receiving elements 22a and 22b of the headphone apparatus 140 is supplied, one terminal of the speaker 21a, and one terminal of the speaker 21b are connected to a line and then connected to the GND via a terminal of the connection plug 41 and the connection jack 42 and via a ferrite bead B1 added to the side of the reproduction apparatus main body 200.

In addition, a band pass filter 62a, a rectification circuit 61a, and a voltage detector 60a are further added to the reproduction apparatus main body 200. One of the two terminals of the voltage detector 60a is connected to the output from a point A. To the other terminal, reference voltage V is input.

In such a case, if the voltage at the point A is higher than the reference voltage V, the voltage detector 60a outputs from 0 to 1 or from 1 to 0. If the voltage at the point A is lower than the reference voltage V, the voltage detector 60a outputs from 1 to 0 or from 0 to 1.

In addition, if one more set of a band pass filter 62b, a rectification circuit 61b, and a voltage detector 60b with different main frequencies from that at the point A is added as shown in Fig. 10B, and a signal outside the audible band at a frequency corresponding to the main frequency of the band pass filter is reproduced at L and R, detection of both L and R becomes possible.

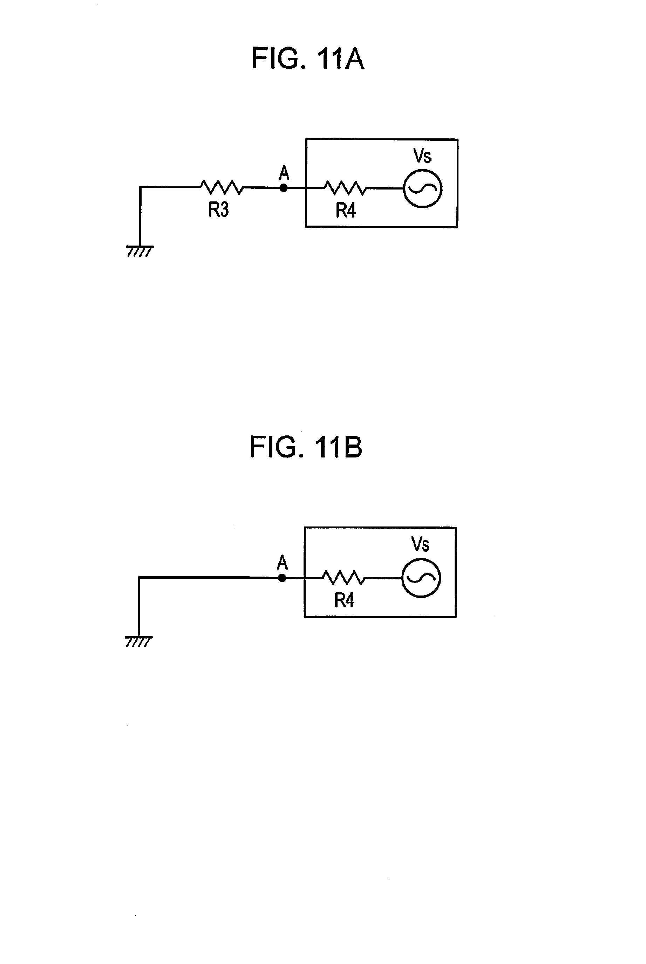

Fig. 11A and 11B are equivalent circuits when the ferrite beads B1 are used. Vs represents a signal generating source, and R4 represents an output impedance of a circuit on a signal. Fig. 11A shows an equivalent circuit when a signal in a high-frequency band is connected. In such a case, the ferrite bead B1 functions as a resistance, and therefore, the ferrite bead B1 is equivalent to a resistance R3 in a high-frequency band. Accordingly, voltage VA at the point A can be represented as VA = {R3/(R3+R4)}Vs with the impedance R3 of the ferrite bead in a high-frequency band.

Since R3 » R4, VA ≈ Vs is obtained, and constant alternating voltage is generated at the point A.

Fig. 11B shows an equivalent circuit when a signal in a low-frequency band is connected. Since the impedance R3 of the ferrite bead B1 can be regarded as zero, the voltage VA at the point A satisfies VA ≈ 0, and the potential at the point A becomes the same as that at the GND.

It is detected whether or not the headphone apparatus 140 is fitted to the ear, by superimposing the signal outside the audible band on the sound signal and collecting the reflection of the signal outside the audible band (a signal in a high-frequency band) superimposed on the sound signal within the ear. The voltage at the point A becomes constant when the signal outside the audible band is received.

When the signal outside the audible band is not received, which is the same as a case in which a signal in a low-frequency band is received, the point A corresponds to the GND.

That is, the output of a voltage detector 60 outputs a signal representing whether or not the headphone apparatus 140 is fitted to the ear. This signal corresponds to a control signal for the accumulating operation given to the reproduction volume accumulation unit 7.

As described above, the ferrite bead B1 can also extract the signal outside the audible band superimposed on the sound signal in order to detect whether or not the headphone apparatus 140 is fitted to the ear. In such a case, it is possible to realize the connection terminals of the connection jack 42 and the connection plug 41 with four terminals. Moreover, it is possible to simplify the configuration of the reproduction apparatus main body 200 with the use of the ferrite bead B1.

In addition, the frequency-dependent resistance unit is not limited to a ferrite bead. Since any configuration is applicable in this example as long as a potential situation in accordance with the presence of the signal outside the audible band can be created, it is also possible to form the frequency-dependent resistance unit in combination of a resistance and an inductance element, for example.

The reproduction apparatus according to the first to fourth embodiment may be a receiver, a radio tuner, or the like which receives and reproduces sound from an external sound source which does not include a sound source 6 therein.

The present disclosure contains subject matter related to that disclosed in Japanese Priority Patent Application JP 2011-028625 filed in the Japan Patent Office on February 14, 2011, the entire contents of which are hereby incorporated by reference.

Although particular embodiments have been described herein, it will be appreciated that the invention is not limited thereto and that many modifications and additions thereto may be made within the scope of the invention. For example, various combinations of the features of the following dependent claims can be made with the features of the independent claims without departing from the scope of the present invention.

It should be understood by those skilled in the art that various modifications, combinations, sub-combinations and alterations may occur depending on design requirements and other factors insofar as they are within the scope of the appended claims or the equivalents thereof.

## Claims

1. A sound signal output apparatus comprising:
a wearing state determination unit which determines whether or not a connected speaker apparatus is fitted to an ear of a user;
a volume adjustment unit which adjusts volume of a sound signal to be supplied to the speaker apparatus; and
an accumulative computation unit which computes an accumulative value of output volume in accordance with a volume level and sound output time of the sound signal, causes the volume adjustment unit to execute volume regulation when the accumulative value reaches a regulatory value, and does not compute the accumulative value during a period in which the wearing state determination unit determines that the speaker apparatus is not fitted to an ear.

2. The sound signal output apparatus according to Claim 1, further comprising:
a signal outside audible band generating unit which generates a signal outside an audible band; and
a signal superimposing unit which superimposes the signal outside the audible band generated by the signal outside audible band generating unit on a sound signal to be supplied to the speaker apparatus;
wherein the wearing state determination unit determines whether or not the speaker apparatus is fitted to the ear based on detection of the signal outside the audible band in a received sound signal supplied from the speaker apparatus.

3. The sound signal output apparatus according to Claim 2, wherein the wearing state determination unit determines that the speaker apparatus is fitted to an ear when an average level of the signal outside the audible band, which has been extracted from the received sound signal, in unit time is higher than a predetermined threshold level.

4. The sound signal output apparatus according to Claim 3, further comprising:
a noise cancelling signal generating unit which generates a noise cancelling signal from the received sound signal supplied from the speaker apparatus; and
an adder which adds the noise cancelling signal to the sound signal to be supplied to the speaker apparatus.

5. The sound signal output apparatus according to Claim 4, wherein the wearing determination unit inputs the received sound signal supplied from the speaker apparatus via a filter corresponding to a band of the signal outside the audible band, and
wherein the noise cancelling signal generating unit inputs the received sound signal supplied from the speaker apparatus via a filter for an audible band.

6. The sound signal output apparatus according to Claim 2, wherein the wearing state determination unit performs terminal voltage detection of a frequency-dependent resistance unit in order to detect the signal outside the audible band in the received sound signal supplied from the speaker apparatus.

7. The sound signal output apparatus according to Claim 6, wherein a ferrite bead is used as the frequency-dependent resistance unit.

8. A speaker apparatus comprising:
a speaker which outputs sound by an output sound signal supplied from a connected sound signal output apparatus;
a sound receiving element for reflected sound in an ear, which is arranged so as to receive reflected sound in the ear of a user in a state in which the speaker apparatus is fitted to the ear of the user; and
an output terminal which supplies a received sound signal obtained by the sound receiving element to the connected sound signal output apparatus.

9. The speaker apparatus according to Claim 8, further comprising:
a sound receiving element for noise collection,
wherein the received sound signal obtained by the sound receiving element for reflected sound in the ear and a received sound signal obtained by the sound receiving element for noise collection are synthesized and output from the output terminal.

10. The speaker apparatus according to Claim 8,
wherein the sound receiving element for reflected sound in the ear is arranged at a position at which the sound receiving element for reflected sound in the ear also functions as a sound receiving element for noise collection.

11. A sound signal output method comprising:
determining whether or not a connected speaker apparatus is fitted to an ear of a user;
computing an accumulative value of output volume in accordance with a volume level and sound output time of a sound signal to be supplied to the speaker apparatus only during a period in which it is determined that the speaker apparatus is fitted to the ear; and
executing volume regulation on the sound signal to be supplied to the speaker apparatus when the accumulative value reaches a regulatory value.
